# EUROPEAN PATENT SPECIFICATION

(11) **EP 3 657 553 B1**
(45) Date of publication and mention of the grant of the patent: **16.06.2021**
(21) Application number: 20151394.2
(22) Date of filing: 22.07.2016
(51) Int. Cl.: H01L 31/05, H01L 31/02

(54) **SOLAR CELL MODULE WITH INTERCONNECTION OF NEIGHBORING SOLAR CELLS ON A COMMON BACK PLANE**
SOLARZELLENMODUL MIT VERBINDUNG VON BENACHBARTEN SOLARZELLEN AUF EINER GEMEINSAMEN RÜCKWAND
MODULE DE CELLULES SOLAIRES AVEC INTERCONNEXION DE CELLULES SOLAIRES ADJACENTES SUR UN PLAN ARRIÈRE COMMUN

(30) Priority: 24.08.2015 US 201514833755
(43) Date of publication of application: 27.05.2020
(62) Divisional of application: 16180678.1
(73) Proprietor: SolAero Technologies Corp., Albuquerque, NM 87123 (US)
(72) Inventor: AIKEN, Daniel, Cedar Crestl, NM 87008 (US); YANG, Lei, Albuquerque, NM 87113 (US); DERKACS, Daniel, Albuquerque, NM 87111 (US); FLYNN, Greg, Albuquerque, NM 87111 (US); RICHARDS, Benjamin, Albuquerque, NM 87111 (US); CLEVENGER, Marvin B., Albuquerque, NM 87111 (US)
(74) Representative: Balder IP Law, S.L.

(56) References cited:
- FR-A5- 2 097 460
- US-A- 4 045 245

## Description

### BACKGROUND OF THE DISCLOSURE

### Field of the Invention

The present invention relates to the field of photoelectric solar cell arrays, and to fabrication processes utilizing, for example, multijunction solar cells based on III-V semiconductor compounds fabricated into multi-cell modules or subassemblies of such solar cells, and an automated process for mounting and interconnection of such subassemblies on a substrate or panel.

### Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology not only for use in space but also for terrestrial solar power applications. Compared to silicon, III-V compound semiconductor multijunction devices have greater energy conversion efficiencies and generally more radiation resistance, although they tend to be more complex to manufacture. Typical commercial III-V compound semiconductor multijunction solar cells have energy efficiencies that exceed 27% under one sun, air mass 0 (AM0), illumination, whereas even the most efficient silicon technologies generally reach only about 18% efficiency under comparable conditions. Under high solar concentration (e.g., 500X), commercially available III-V compound semiconductor multijunction solar cells in terrestrial applications (at AM1.5D) have energy efficiencies that exceed 37%. The higher conversion efficiency of III-V compound semiconductor solar cells compared to silicon solar cells is in part based on the ability to achieve spectral splitting of the incident radiation through the use of a plurality of photovoltaic regions with different band gap energies, and accumulating the current from each of the regions.

Typical III-V compound semiconductor solar cells are fabricated on a semiconductor wafer in vertical, multijunction structures. The individual solar cells or wafers are then disposed in horizontal arrays, with the individual solar cells connected together in an electrical series circuit. The shape and structure of an array, as well as the number of cells it contains, are determined in part by the desired output voltage and current.

In satellite and other space related applications, the size, mass and cost of a space vehicle or satellite power system are dependent on the power and energy conversion efficiency of the solar cells used. Putting it another way, the size of the payload and the availability of on-board services are proportional to the amount of power provided. Thus, as payloads become more sophisticated and require more power, both the power-to-weight ratio (measured in watts per kg) and power-to-area ratio (measured in watts per square meter) of a solar cell array or panel become increasingly more important, and there is increasing interest in lighter weight, densely packed solar cell arrays having both high efficiency and low mass.

Space applications frequently use high efficiency multijunction III/V compound semiconductor solar cells. Compound semiconductor solar cell wafers are often costly to produce. Thus, the waste that has conventionally been accepted in the art when cutting the rectangular solar cell out of the substantially circular solar cell wafer can imply considerable cost.

Solar cells are often produced from circular or substantially circular wafers sometimes 100 mm or 150 mm in diameter. Large solar cells (i.e. with, for example, an area from 25 to 60 cm² representing one-quarter or more of the area of the wafer) are conventionally preferred so as to minimize the costs associated with the assembly of the solar cells onto a support to form a solar cell module. However, the use of large solar cells results in poor wafer utilization, and large solar cells often present issues of defects or variation in the material quality across the surface of the wafer. Also, larger solar cells are fragile and present handling challenges during subsequent fabrication steps that result in breakage of the wafer or solar cells and corresponding lower manufacturing yield. Moreover, large solar cells of predetermined size cannot be easily or efficiently accommodated on panels of arbitrary aspect ratios and configurations which may vary depending upon the "wing" configuration of the satellite or space vehicle. Also, large solar cells are rigid and can sometimes be problematic in terms of meeting requirements for flexibility of the solar cell assembly or solar array panel. Sometimes, flexibility is desired so that the solar cell assembly or the solar array panel can be bent or rolled, for example, so that it is displaceable between a stowed position in which it is wound around a mandrel or similar, and a deployed position extending outward from, for example, a space vehicle so as to permit the solar cells to receive sunlight over a substantial area. Sometimes, large solar cells can be problematic from the perspective of providing a flexible assembly or panel that can be readily bent, wound, etc. without damage to the solar cells and their interconnections.

It is possible to reduce the amount of waste by dividing a circular or substantially circular wafer not into one or two single cells, but into a large number of smaller cells. By dividing a circular or substantially circular wafer into a large amount of relatively small cells, most of the wafer surface can be used to produce solar cells, and the waste is reduced. For example, a solar cell wafer having a diameter of 100 mm or 150 mm and a surface area in the order of 80 cm² or 180 cm² can be used to produce a large amount of small solar cells, such as square or rectangular solar cells, each having a surface area of less than 5 cm², or in some embodiments less than 1 cm², less than 0.1 cm², less than 0.05 cm², or less than 0.01 cm². For example, substantially rectangular -such as square- solar cells can be obtained in which the sides are less than 10, 5, 3, 2, 1 or even 0.5 mm long. Thereby, the amount of waste of wafer material can be substantially reduced, and at the same time high utilization of the wafer surface can be obtained. Also, when dividing a solar cell wafer into a relatively large number of solar cells, solar cells obtained from a more or less defective region of the wafer can be discarded, or "binned" as lower performance solar cells, that is, not used for the manufacture of the solar cell assemblies. Thus, a relatively high quality of the solar cell assemblies in terms of performance of the solar cells can be achieved, while the amount of waste is kept relatively low.

However, the use of a large number of relatively small solar cell involves the drawback that for a given effective surface area of the final solar cell assembly or solar array panel, there is an increased number of interconnections between solar cells, in a parallel and/or in series, which may render the process of manufacturing the solar cell assembly or the panel more complex and/or expensive, and which may also render the entire circuit less reliable, due to the risk for low reliability, low yield, or other manufacturing difficulties or errors due to defective or less-than-ideal interconnections between individual solar cells.

US-4045245-A discloses a solar cell package comprising an array of circular solar cell wafers each having a diameter of for example three inches, arranged in a support member. The solar cell wafers are electrically interconnected by means of conductors extending through a thermally conductive but electrically insulative material, for example, an alumina filled silicone.

FR-2097460-A5 discloses a deployable solar cell panel with solar cells connected in series on a flexible support.

### SUMMARY OF THE DISCLOSURE

It is an object of the present invention to provide an improved multijunction solar cell assembly or module comprising a plurality of solar cells.

It is an object of the present invention to provide a platform or substrate for the series and/or parallel connection of discrete groups of solar cells.

It is an object of the present invention to provide a lightweight solar cell assembly or module that is suitable for automated manufacturing processes.

It is another object of the invention to provide a flexible solar cell array module with high W/kg and W/m² and low cost.

It is another object of the invention to provide a solar cell assembly or module that utilizes an array of small solar cells, for example, solar cells each having a surface area of less than 5 cm², or in some embodiments less than 1 cm², less than 0.1 cm², less than 0.05 cm², or less than 0.01 cm², for example, substantially rectangular -such as square- solar cells in which the (longest) sides are less than 10, 5, 3, 2, 1 or even 0.5 mm long.

Some implementations or embodiments may achieve fewer than all of the foregoing objects.

Briefly, and in general terms, the present disclosure provides a solar cell assembly comprising: a support comprising a first side and an opposing second side; a first conductive layer comprising first and second spaced-apart conductive portions disposed on the second side of the support; a plurality of solar cells mounted on the first side of the support, each solar cell of the plurality of solar cells comprising a top surface including a contact of a first polarity type, and a rear surface including a contact of a second polarity type; a plurality of first vias in the support extending from the first side of the support to the second side of the support; a plurality of second vias in the support extending from the first side of the support to the second side of the support; a plurality of first conductive interconnects extending from the first side of the support to the first conductive portion of the first conductive layer, each respective interconnect making electrical contact with the contact of the first polarity type of a respective solar cell and extending through a respective one of the first vias to make electrical contact with the first conductive portion of the first conductive layer disposed on the second side of the support; a plurality of second conductive interconnects extending from the first side of the support to the second conductive portion of the first conductive layer, each respective interconnect making electrical contact with the contact of the second polarity type of a respective solar cell and extending through a respective one of the second vias to make electrical contact with the second conductive portion of the first conductive layer disposed on the second side of the support; and a first terminal of the assembly of a first polarity type disposed on the second side of the support and connected to the first conductive portion of the first conductive layer; a second terminal of the assembly of a second polarity type disposed on the second side of the support and connected to the second conductive portion of the first conductive layer. The solar cells have a size of less than 5 cm². The support is flexible.

In some embodiments, the first conductive portion of the first conductive layer comprises a plurality of parallel strips of equal width, and the second conductive portion comprises a plurality of parallel strips of equal width, with the parallel strips of the first and second portions being interdigitated.

In some embodiments the solar cell assembly further comprises a second conductive layer comprising spaced-apart conductive portions disposed on the first side of the support, with each of the solar cells mounted on a respective one of the conductive portions, and wherein the first and second conductive portions of the first conductive layer and the spaced-apart conductive portions of the second conducive layer, have a thickness in the range of 5 to 50 microns.
In some embodiments, the first and second conductive interconnect comprises an electroplated metal conductor extending from the surface of the first side of the support to the respective first and second conductive portions of the first conductive layer.

In some embodiments the solar cell assembly further comprises a first set of interconnect wires, each wire extending from a contact of first polarity of each solar cell to a respective metal conductor on the surface of the first side of the support, and a second set of interconnect wires, each wire extending from a contact of second polarity of each solar cell to a respective metal conductor on the surface of the first side of the support.

In some embodiments, the plurality of solar cells disposed on the support are electrically connected in parallel.

In some embodiments the plurality of solar cells are disposed adjacent to one another are electrically connected in series.

In some embodiments, a first set of the plurality of solar cells disposed on the support are electrically connected in parallel, and a second set of the plurality of solar cells on the support are connected in electrical series.

In some embodiments, the support is composed of a poly (4,4'-oxydiphenylene-pyromellitimide) material.

In some embodiments, each of the conductive interconnects comprises a single conductive element extending from the contact on the solar cell to the first or second conductive portions on the second side of the support through the via.

In some embodiments, each via has a diameter of between 100 and 200 microns.

In some embodiments, the first terminal of the assembly is disposed on a first peripheral edge of the assembly and connected to the first conductive portion of the first conductive layer.

In some embodiments, the second terminal of the assembly is disposed on a second peripheral edge of the assembly extending parallel to the first peripheral edge of the assembly, and connected to the second conductive portion of the first conductive layer.

In some embodiments there further comprises a bypass diode mounted in parallel with the solar cells and functioning as a bypass diode of the entire solar cell assembly.

In some embodiments, the bypass diode has a top terminal of a first conductivity type and a bottom terminal of a second conductivity type, and the bottom terminal is mounted on and electrically connected to the first conductive layer.

In some embodiments, the vias are arranged between the adjacent strips of the first and second conductive portions.

In some embodiments, the assembly further comprises a bypass diode which can be mounted on, for example, any of the first and second surfaces and function as a bypass diode for the entire solar cell assembly or subportions or groups of solar cells thereof. Bypass diodes are frequently used in solar cell assemblies comprising a plurality of series connected solar cells or groups of solar cells. One reason for the use of bypass diodes is that if one of the solar cells or groups of solar cells is shaded or damaged, current produced by other solar cells, such as by unshaded or undamaged solar cells or groups of solar cells, can flow through the by-pass diode and thus avoid the high resistance of the shaded or damaged solar cell or group of solar cells. The bypass diodes can be mounted on one of the conductive layers and comprise an anode terminal and a cathode terminal. The diode can be electrically coupled in parallel with the semiconductor solar cells and configured to be reverse-biased when the semiconductor solar cells generate an output voltage at or above a threshold voltage, and configured to be forward-biased when the semiconductor solar cells generate an output voltage below the threshold voltage. Thus, when the solar cell assembly is connected in series with other solar cell assemblies, the bypass diode can serve to minimize the deterioration of performance of the entire string of solar cell assemblies when one of the solar cell assemblies is damaged or shaded.

The contact of a first polarity type can be for example a cathode contact in embodiments in which the solar cell is an n-on-p configuration, and the contact of a second polarity type can be for example an anode contact in embodiments in which the solar cell is an n-on-p configuration.

In some embodiments, a plurality of solar cells are disposed closely adjacent to one another on each of the strips, separated by a distance of between 5 and 25 microns.

In some embodiments, each of the solar cells have a dimension in the range of 0.5 to 10 mm on a side.

In some embodiments, the via has a diameter of between 100 and 200 microns.

In some embodiments, the first terminal of the module is disposed on a first peripheral edge of the module.
In some embodiments, the second terminal of the module is composed of a metallic strip extending parallel to the first peripheral edge of the module.

In some embodiments of the disclosure, the first terminal and the second terminal are arranged in correspondence with opposite peripheral edges of the support.

In some embodiments, the solar cells are multijunction III/V compound semiconductor solar cells.

It has been found that this arrangement is practical and appropriate for automated manufacturing processes. The solar cells can be tightly packed adjacent to one another at one side of the support, whereas the other side of the support is used as a conductive backplane to provide an electrical element that connects some or all of the solar cells in parallel.

In another aspect, the present disclosure provides a method of manufacturing a solar cell assembly having between 16 and 100 solar cells, in which the solar cells are positioned and placed on a conductive portion of a support, so that the contact or contacts at the rear surface of each solar cell are electrically connected on either (i) the top side of the support, or (ii) the bottom side of the support, or (iii) both (i) and (ii), which thus serves to interconnect the solar cells in parallel.

In some embodiments of the disclosure, each solar cell has a surface area of less than 1 cm². The approach of the disclosure can be especially advantageous in the case of relatively small solar cells, such as solar cells having a surface area of less than 1 cm², less than 0.1 cm² or even less than 0.05 cm² or 0.01 cm². For example, substantially rectangular -such as square- solar cells can be obtained in which the sides are less than 10, 5, 3, 2, 1 or even 0.5 mm long. This makes it possible to obtain rectangular solar cells out of a substantially circular wafer with reduced waste of wafer material, and the approach of the disclosure makes it possible to easily place and interconnect a large number of said solar cells in a parallel, so that they, in combination, perform as a larger solar cell.

In some embodiments of the disclosure, the conductive layer comprises copper.

In some embodiments of the disclosure, the support comprises a KAPTON® film, the conductive layer being placed on the KAPTON® film. The option of using a KAPTON® film for the support is practical for, for example, space applications. KAPTON® is a trademark of E.I. du Pont de Nemours and Company. The chemical name for KAPTON® is poly (4,4'-oxydiphenylene-pyromellitimide). Other polyimide film sheets or layers may also be used.

In some embodiments of the disclosure, the solar cell assembly has a substantially rectangular shape and a surface area in the range of 25 to 400 cm².

In some embodiments of the disclosure, the method comprises the step of obtaining at least a plurality of the solar cells by dividing, for example cutting, at least one solar cell wafer into at least 10 substantially square or rectangular solar cells, such as into at least 100 or into at least 500 solar cells or more. In some embodiments of the disclosure, after dividing said at least one solar cell wafer into a plurality of substantially square or rectangular solar cells, some of said solar cells are selected so as not to be used for producing the solar cell assembly; the solar cells selected not to be used for producing the solar cell assembly may correspond to a defective region of the solar cell wafer. Thereby, overall efficiency of the solar cell assembly is enhanced.

In some embodiments of the disclosure, the conductive interconnects are wires, and in some embodiments of the disclosure the method comprises wire ball bonding the wires to the contacts of the solar cell of first and second polarity type and/or to the contact pads of the vias.

In some embodiments of the disclosure, the solar cell assemblies are flexible. Thus, when the solar cell assemblies are arranged on a substrate with a second solar cell assembly partly overlapping with a first solar cell assembly, the second solar cell assembly can, due to its flexibility, adapt so that part of it extends in parallel with the first solar cell assembly, that is, along a top surface of the substrate, whereas another part of it is curved so that it extends upwards from the substrate in the vicinity of an edge of the first solar cell assembly, and overlies a portion of the first solar cell assembly in the vicinity of said edge. Thus, in some embodiments of the disclosure, the solar cell assemblies are placed so that at least a second solar cell assembly partially overlaps at least a first solar cell assembly, whereby the second solar cell assembly adapts it shape accordingly, whereby part of the second solar cell assembly and at least part of the first solar cell assembly are arranged in one plane, and at least another part of the second solar cell assembly is arranged in a different plane, parallel with the first plane.

### BRIEF DESCRIPTION OF THE DRAWINGS

To complete the description and in order to provide for a better understanding of the disclosure, a set of drawings is provided. Said drawings form an integral part of the description and illustrate embodiments of the disclosure, which should not be interpreted as restricting the scope of the disclosure, but just as examples of how the disclosure can be carried out. The drawings comprise the following figures:
Figure 1A is a perspective view of a support that can be used for fabricating a module according to the present disclosure depicting metallization over the top and bottom surfaces;
Figure 1B is a perspective view of the support of FIG. 1A after a step of forming a plurality of grooves in the bottom metal layer of the support in a first embodiment;
Figure 1C is a perspective view of the support of FIG. 1A after a step of forming a plurality of spaced apart metal pads in the top metal layer of the support in a first embodiment;
Figure 1D is a cross-sectional view of the support of FIG. 1C through the 1D-1D plane shown in FIG. 1C;
Figure 1E is an enlarged perspective view of one of the metal pads on the support as shown in FIG. 1C;
Figure 1F is a perspective view of the bottom of the support as shown in FIG. 1B after fabrication of two rows of vias;
Figure 1G is a perspective view of a solar cell mounted on the support;
Figure 2A is a top perspective view of the support in a second embodiment in which only the bottom surface is metallized;
Figure 2B is a top perspective view of the support of FIG. 2A in which two rows of vias have been fabricated, after metallization of the vias;
Figure 2C is a bottom perspective view of the support of FIG. 2B depicting an embodient of metallization of the bottom surface similar to that of FIG. 1B;
Figure 2D is a top perspective view of a portion of the support of FIG. 2B after which two rows of solar cells have been mounted;
Figure 2E is an enlarged perspective view of one of the solar cells in FIG. 2D mounted on the support;
Figure 2F is a perspective view of a portion of the support of another embodiment in which an adhesive patch is applied to the surface of the support, after bonding a solar cell to the support and after connection of a first interconnect to a pad on one via;
Figure 3A is a top perspective view of the module with an array of solar cells mounted on the surface;
Figure 3B is a top perspective view of the module of FIG. 3A after attachment of the interconnects;
Figure 4A is a schematic diagram of the one row of the components of the module;
Figure 4B is a schematic diagram of an array of solar cells as seen from the back side of the support, with all of the solar cells connected in parallel;
Figure 4C is a schematic diagram similar to the one of figure 4B, with all of the solar cells connected in series;
Figure 4D is a schematic diagram similar similar to the one of figure 4B, with some solar cells connected in series, and some in parallel;
Figure 4E is a bottom plan view of the module showing the location of the solar cells on the top surface, as depicted in dashed line, further depicting the location of the vias with respect to the array of solar cells;
Figure 4F is a bottom plan view of the module of FIG. 4E with the solar cells connected in parallel;
Figure 5A is a cross-sectional view of two adjacent solar cells mounted on the module of FIG. 3A through the 5A-5A plane;
Figure 5B is a cross-sectional view of the two solar cells of FIG. 3B through the 5B-5B plane after an interconnect has been attached to the top contact of the solar cell on the left, and the contact pad of the adjacent via;
Figure 5C is a cross sectional view of the two solar cells of FIG. 3B through the 5C-5C plane after an interconnect has been attached to the bottom contact of another solar cell, and the contact pad of the adjacent via.

### DETAILED DESCRIPTION

Details of the present disclosure will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

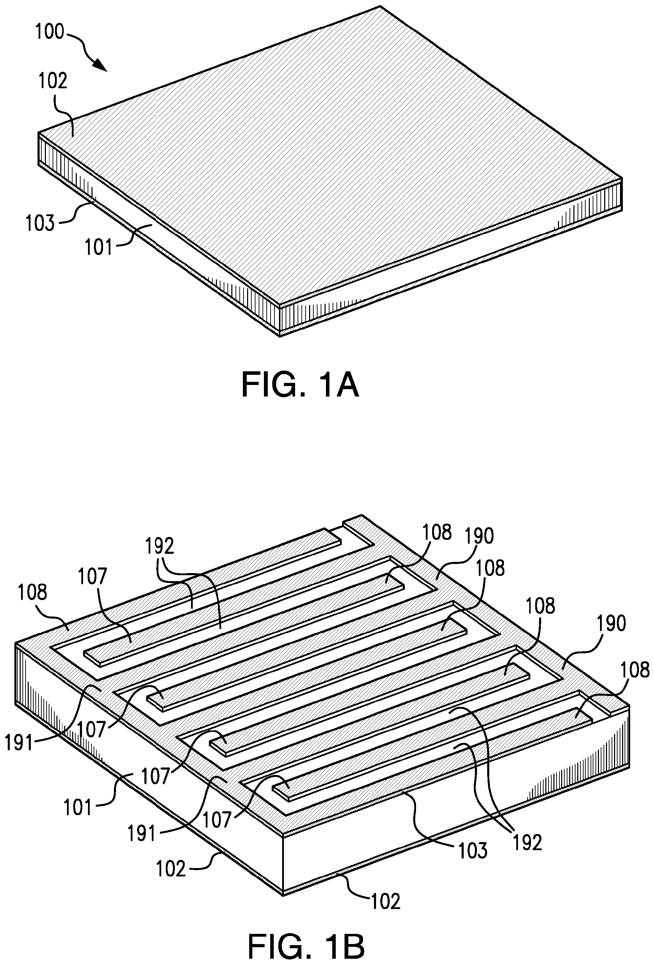

Figure 1A illustrates an example of a support 100 that can be used in an embodiment of the disclosure in the fabrication of the modular subassembly. The support comprises an insulating support layer 101 and a conductive metal layer 102 arranged on a top surface of the support layer 101 and a conductive metal layer 103 arranged on a bottom surface of the support layer 101. In some embodiments of the disclosure, the metal layer 102 is a copper layer, having a thickness in the range of from 1 µm and up to 50 µm. In some embodiments of the disclosure, the support layer 101 is a KAPTON® sheet. A polyimide film sheet or layer may also be used. Preferably the metal layer is attached to the support layer in an adhesive-less manner, to limit outgassing when used in a space environment. In some embodiments of the disclosure the support layer can have a thickness in the range of 1 mil (25.4 µm) to 4 mil (101.6 µm).

Although the support 100 is depicted in Fig. 1A as the size and shape of the ultimate module, which may be a square, rectangular or another geometrically shaped element ranging from 1 inch to 6 inches on a side, the support 100 may be fabricated out of a roll or larger support material such as a polymide film. Such material may be automatically processed and cut to produce the individual support 100 depicted in Fig. 1A, or subsequently depicted processed structures. A description of such fabrication processes goes beyond the scope of the present disclosure, but is described in the related applications.

In some embodiments, the support 100 may be cut to a different geometric shape, e.g. triangular, hexagonal, octagonal, or with irregular or non-linear edges, with one or more legs or extensions that support other electronic components or conductive traces that attach to the support.

Figure 1B is a perspective view of the support 100 of FIG. 1A after a step of forming a plurality of grooves in the bottom metal layer 103 of the support in a first embodiment. Figure 1B illustrates the support 100 of Figure 1A after a step in which a portion of the metal layer 103 has been removed, by for example etching or laser scribing, whereby channels or grooves 192 are formed traversing the metal layer 103, separating it into at least a plurality of strips 107, 108, extending in parallel and in some embodiments connected to each other at a terminal 190, 191 respectively on opposing peripheral edges of the support 100.

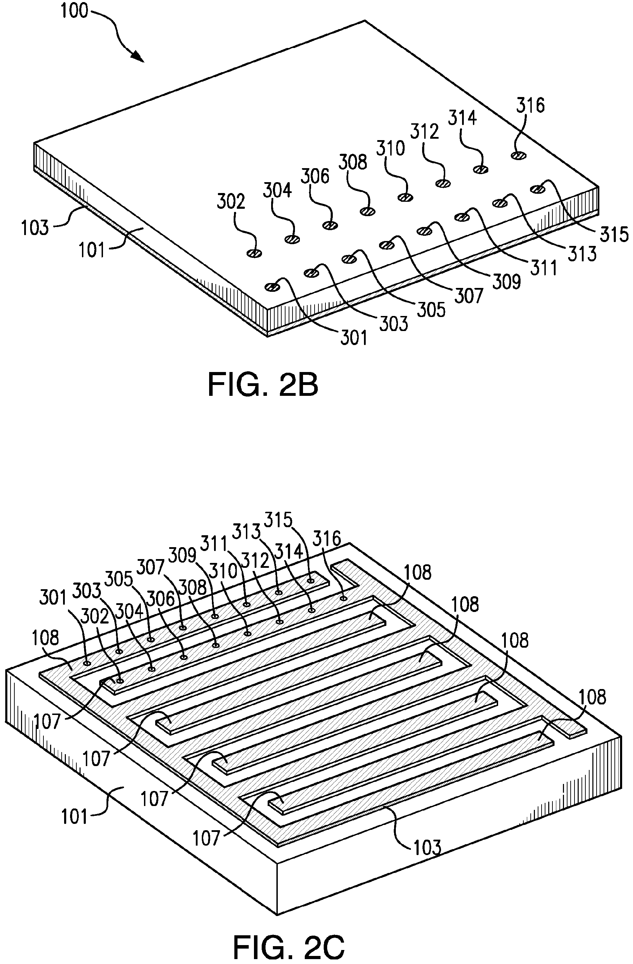

In another embodiment, the grooves etc. are V-shaped or triangular, and so are the strips such as depicted in Figures 2B and 3C of parent application Serial No. 14/719,111. The use of this kind of strips the width of which increases along the strip when moving from the free end of the strip to the end where the strip is connected to the terminals 190, 191, is that when in use and with solar cells arranged in a row along the strip, current will flow in one direction, and the current will be lowest towards the free end of the strip (where the current corresponds to the one produced by one solar cell), and higher towards the end where the strip connects to the terminal 190, 191 (where the current is the sum of the currents produced by the solar cells arranged on the strip). Thus, the need for a sufficient cross section of conductive material is higher towards the end where the strip mates with the terminals 190, 191. Thus, the increasing width corresponds to an optimization of the use of conductive material, which can be important especially for space applications.

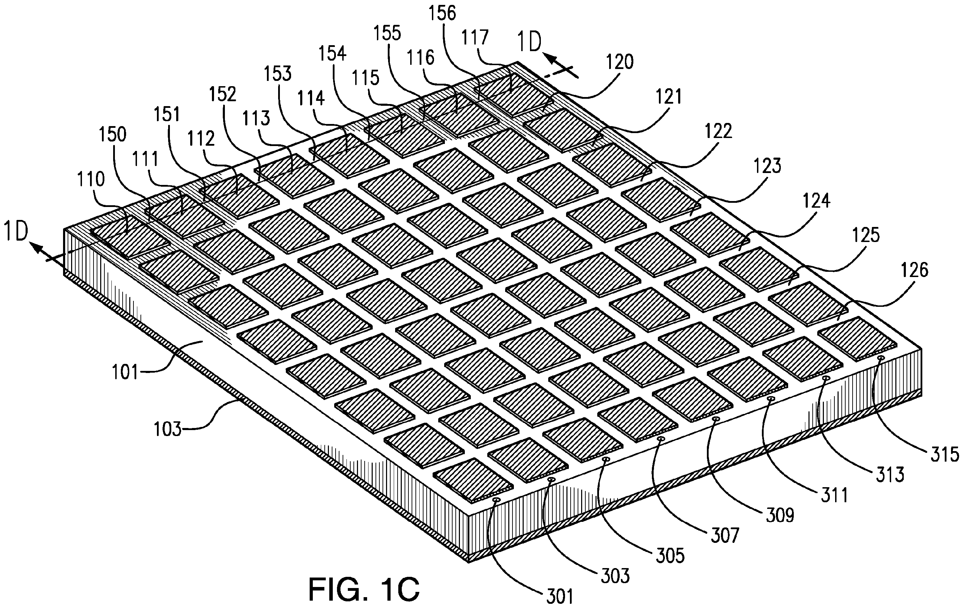

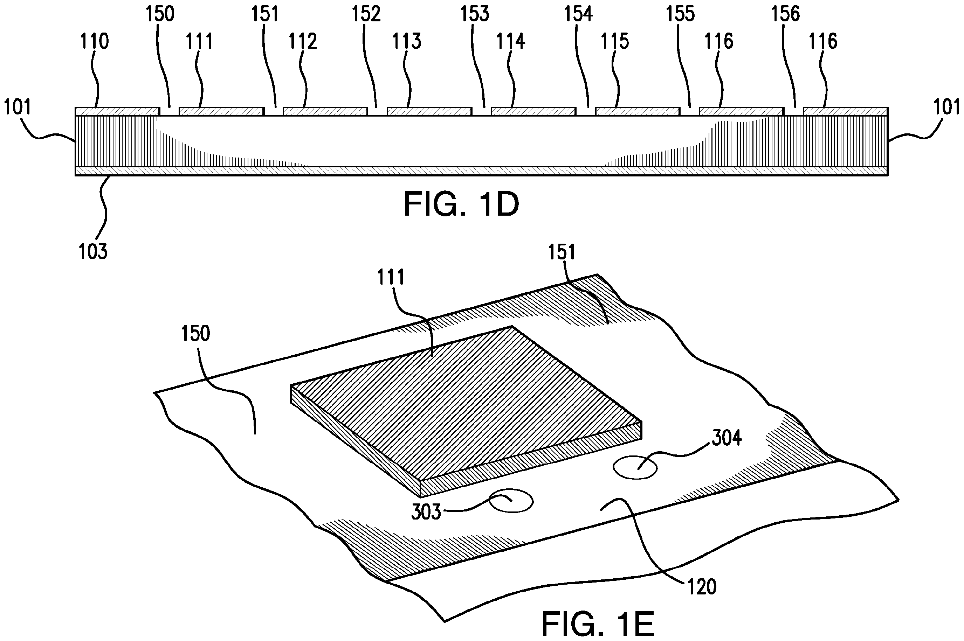

Figures 1C and 1D show the support of Figure 1A after a step of forming a plurality of spaced apart metal pads 110-117 in the top metal layer 102 of the support, for example by etching or laser scribing, creating channels or grooves 120-126 and 150-156. Figure 1E shows an enlarged perspective view of one of the metal pads 111, placed adjacent to two vias 303 and 304. Further vias 301, 305,..., 315 are shown in Figure 1C.

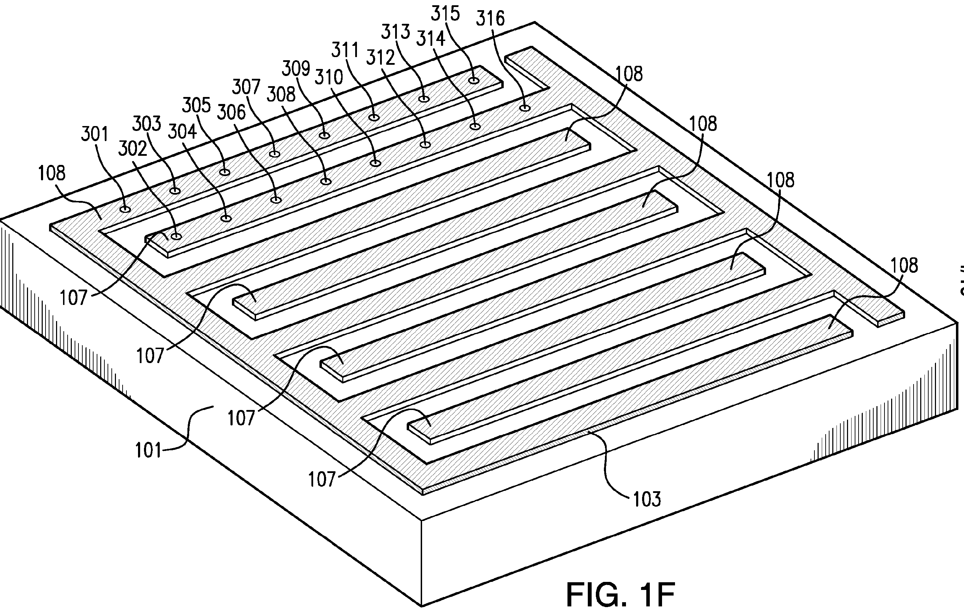

Figure 1F is a perspective view of the bottom of the support as shown in FIG. 1B after fabrication of two rows of vias 301, 303,... 315 and 302, 304..., 306, respectively. These vias can be used to connect solar cells placed on the metal pads 110-117, to the strips formed in the bottom metal layer 103. The vias can be filled with conductive material, or be used to accommodate for example an interconnecting wire. When the vias are filled with a conductive material, interconnects such as wires can be electrically connected to the top and bottom surfaces or contact pads of the vias and to respective contacts on the solar cells, so as to establish electrical connection between the electrical contacts on the solar cells and the bottom metal layer 103.

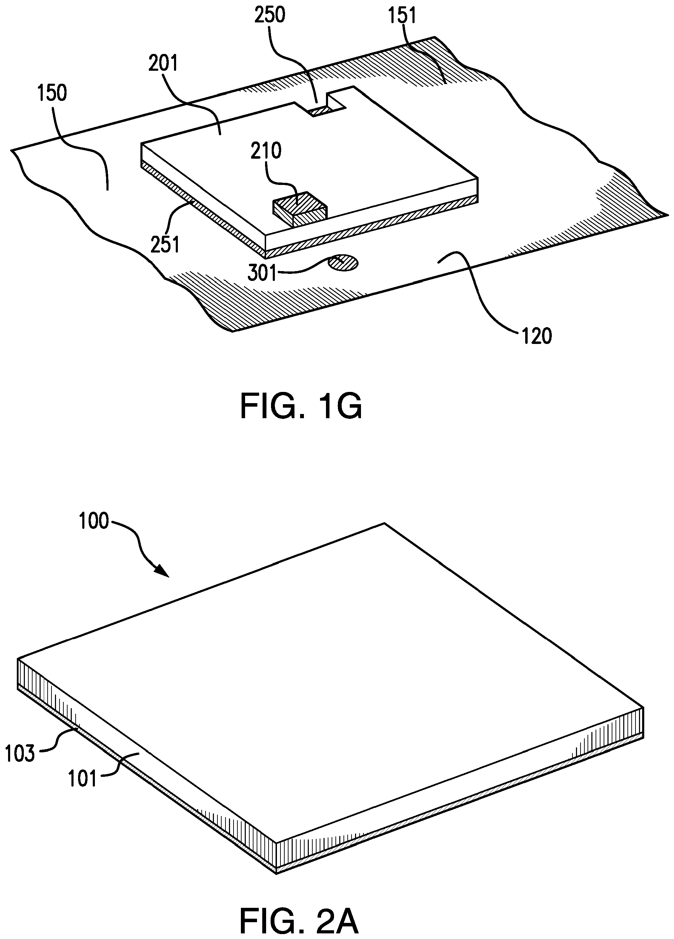

Figure 1G is a perspective view of a solar cell 201 with a top surface having a contact pad 201 corresponding to a contact of a first polarity type, a bottom surface with a metal layer 251 corresponding to a contact of a second polarity type. A cut-out 250 provides access to the contact of the second polarity type from above. The solar cell is 201 mounted on the support, adjacent to a via 301. The solar cell can in this embodiment be placed on one of the metallic contact pads 110-117 shown in figure 1C.

Figure 2A is a top perspective view of the support 100 in a second embodiment in which only the bottom surface is metallized, so that the support layer 101 features a conductive layer 103 on only one of its two sides.

Figure 2B is a perspective view of the support of FIG. 2A after the next process step of providing vias 301, 303, ... 315 in a first row, and 302, 304, ... 316 in a second row, . extending into or through the support 100 according to the present disclosure. The vias can be provided using any suitable means. Figure 2B illustrates how in this embodiment the vias 301, ... 315 and 302, ... 316 may be plated with metal so as to form a conductive path from the bottom metal layer 103 to the top surface of the support.

Figure 2C is a bottom perspective view of the support of FIG. 2B in first embodiment and illustrates how the vias traverse the body 101 and emerge at the bottom surface thereof and stop at the top of the metal film strips 107 and 108. (Only the first two rows of vias 301, ... 315 and 302, ... 316 are shown for simplicity).

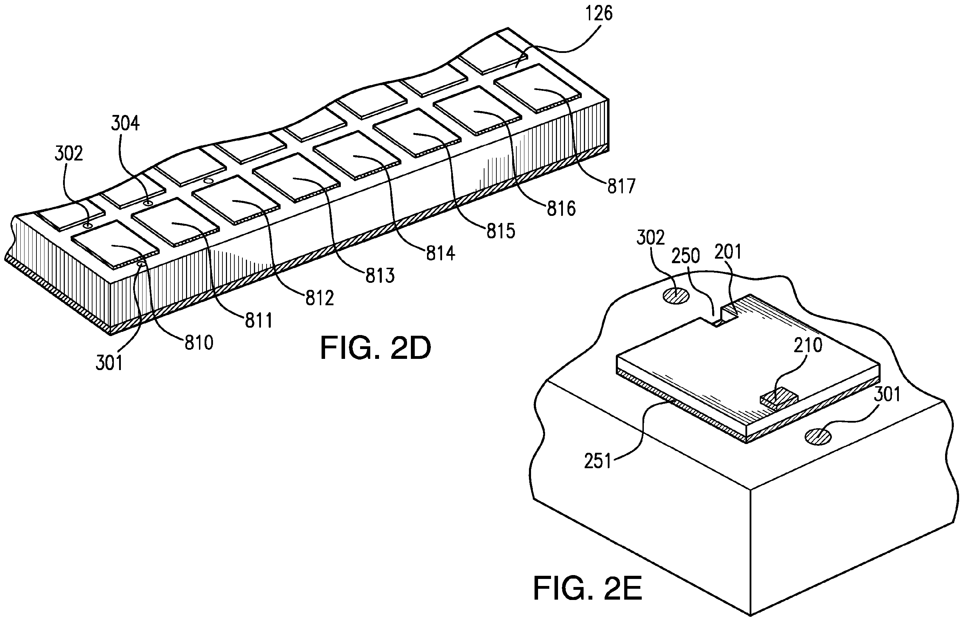

Figure 2D is a perspective view of the support of FIG. 2B after the next process step of mounting a plurality of solar cells 810, 811, ... 817 on a first row along the top surface of the support according to the present disclosure.

Figure 2E is an enlarged perspective view of a single solar cell. Each solar cell has a top surface in which a contact pad of a first polarity (in the enlarged depiction represented by 210 for solar cell 207), such as a cathode contact pad, is provided. Two vias 301 and 302 are shown, adjacent to the solar cell.

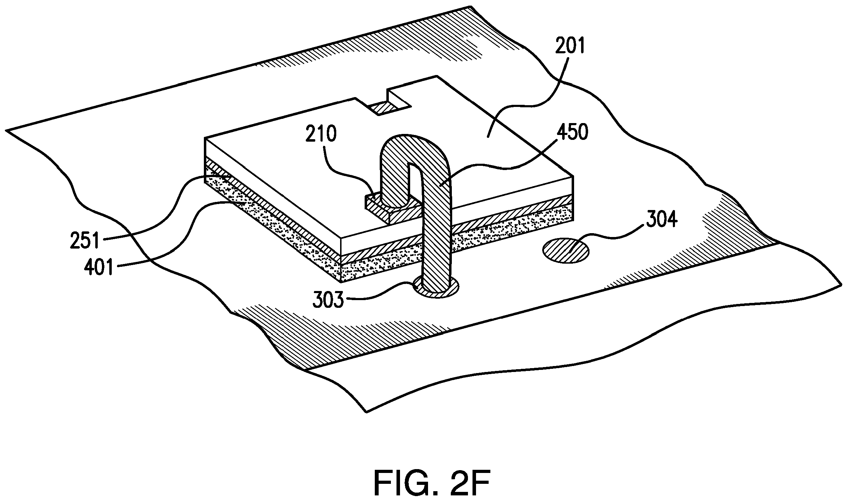

Figure 2F is a perspective view of a portion of the support of another embodiment in which a solar cell has been bonded to the support using an adhesive patch 401; the adhesive patch 401 can be used to adhere a solar cell to the support. Two vias 303 and 304 are shown. The solar cell features a top contact with contact pad 210 corresponding to a contact of a first polarity type, and a conductive layer 251 at the bottom of the solar cell, corresponding to a contact of a second polarity type. This conductive layer 251 is placed on the adhesive patch 401. Access to the conductive layer 251 from above is provided for by the recess or cut-out 250.

A first interconnect 450 has been connected to electrically connect the contact pad 210 to the conductive material filling via 303, thereby establishing contact between the contact pad 210 and the conductive portion 108 (see Figure 2C) on the other side of the support.

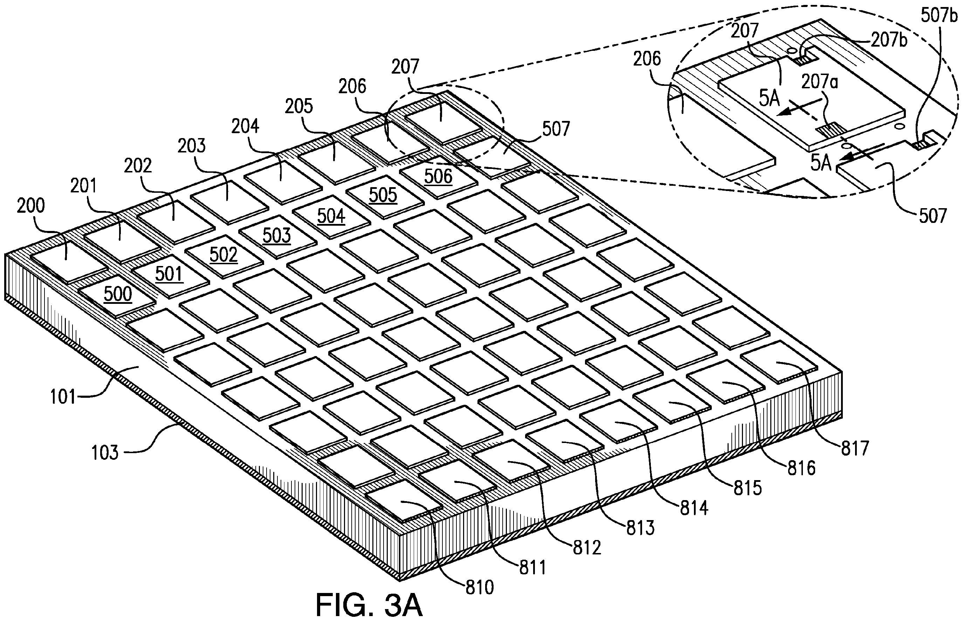

Figure 3A is a top perspective view of the module with an array of solar cells 200-207, 500-507, 810-817 mounted on the surface of the first side of the support. In the enlarged portion, a contact 207a of the first polarity type and two contacts 207b, 507b of the second polarity type of are shown in relation to two solar cells 207, 507.

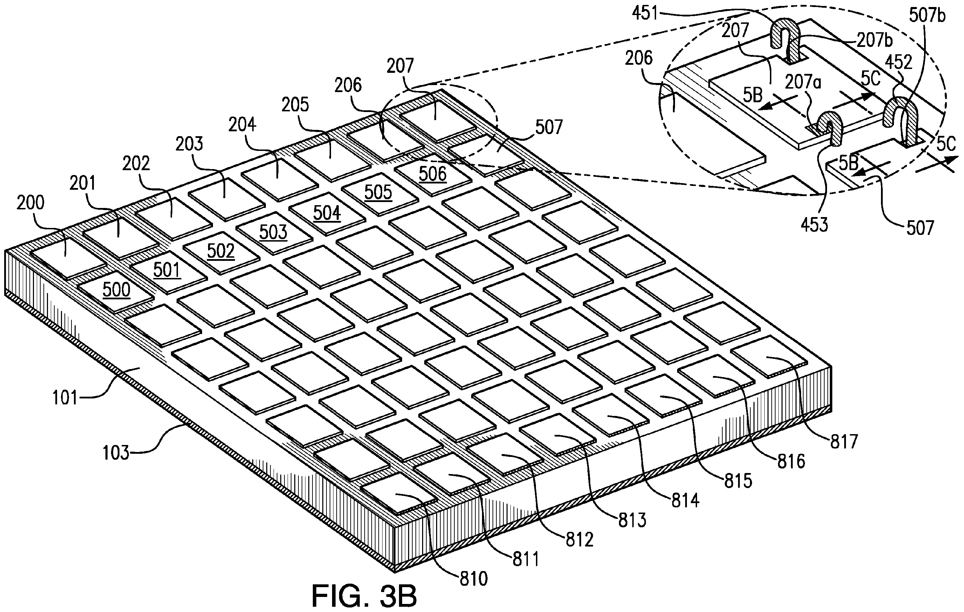

Figure 3B is a top perspective view of the module of FIG. 3A after attachment of three interconnects 451, 452 and 453, two of them attached to the contacts 207b, 507b of the second polarity type and one of them attached to the contact of the first polarity type 207a, in order to electrically connect these contacts to the respective conductive portions on the other side of the support, through the vias.

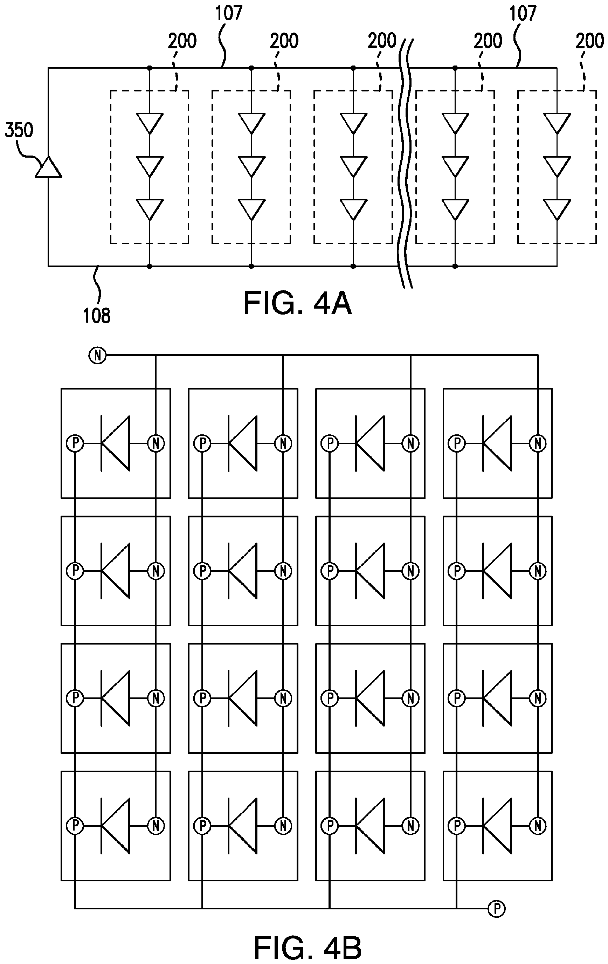

Figure 4A is a schematic diagram of one row of the components of the module. A plurality of solar cells 200 are connected in parallel between two bus bars 107 and 108, corresponding to the second and to the first conductive portions, respectively, and with a bypass diode 350 common to the plurality of solar cells. Each solar cell is a multijunction solar cell.

Figure 4B schematically illustrates solar cells showing contacts of two polarities, for example, a contact of a first polarity type (henceforth: "N contact") and a contact of a second polarity type (henceforth: "P contact"). This kind of solar cells can be arranged in an array. Using the backplane of the support, these solar cells can be interconnected in different ways, for example, as shown in Figures 4B-4D.

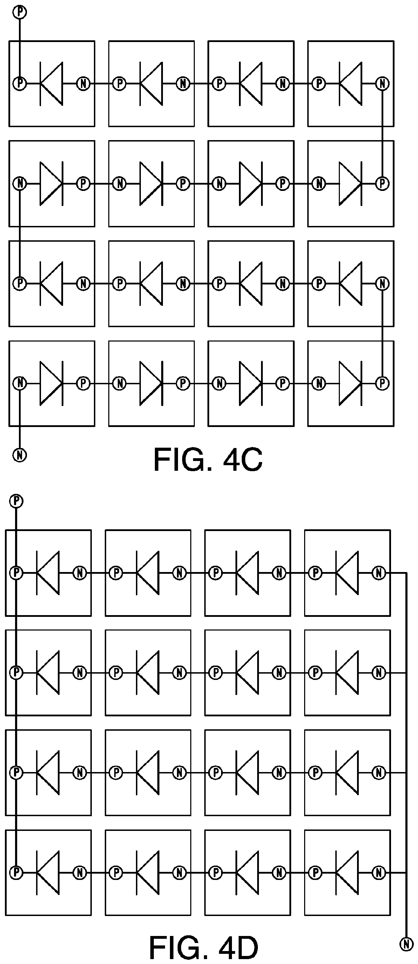

Figure 4B is a plan view of the array with all of the solar cells connected in parallel. This can be achieved, for example, by connecting the P contacts of the solar cells through one of the conductive portions 107 or 108, and the N contacts of all of the solar cells to another one of the conductive portions 108 or 107, through vias in the support, as previously explained. Figure 4C is a plan view of the array with all of the solar cells connected in series. Also this can be carried out using, for example, conductive portions or traces at a rear surface of the support to interconnect a P contact of one solar cell with an N contact of a following solar cell, in a string of solar cells, etc. In other embodiments, at least part of the interconnections between P contacts and N contacts can be carried out directly using interconnects, without using the vias in the support.
Figure 4D is a plan view of the array with some solar cells connected in series, and some in parallel. In some embodiments, this can be achieved by connecting a set of solar cells in series electrically connecting the P contact of one solar cell to the N contact of the next solar cell forming a string of solar cells, and thereafter connecting a plurality of said strings in parallel, by connecting the N contact of the first solar cell in each string to one of the conductive portions 107 or 108 (cf. Figure 2C) on the rear surface of the support, and the P contact of the last solar cell in each string to another conductive portion 108 or 107 of the support, through the respective vias in the support.

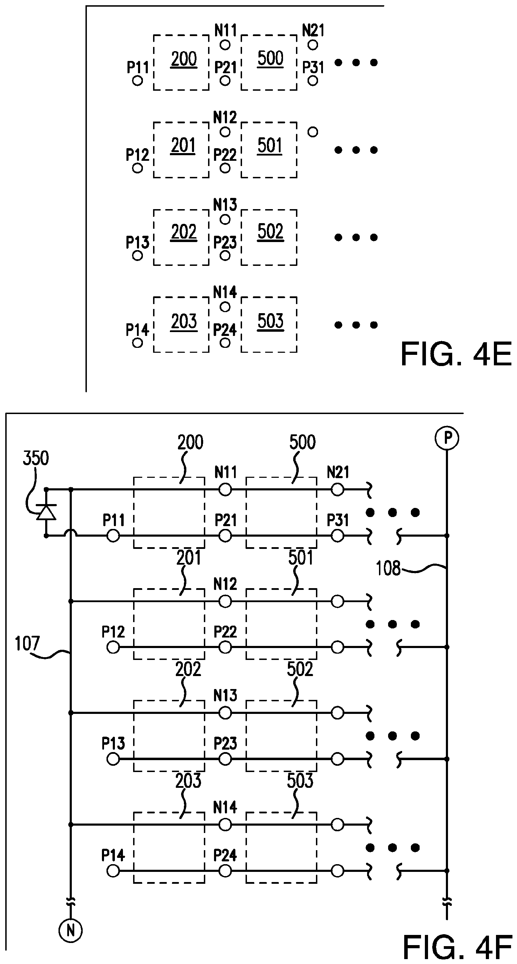

Figure 4E is a bottom plan view of the module showing the location of the solar cells 200-203, 500-503 on the top surface, as depicted in dashed lines and further depicting the location of the vias with respect to the array of solar cells on the top surface of the module, as depicted in dashed lines. For example, via P11 is associated to the contact of the second polarity type of solar cell 200, and via N11 is associated to the contact of the first polarity type of solar cell 200; via P21 is associated to the contact of the second polarity type of solar cell 500, and via N21 is associated to the contact of the first polarity type of solar cell 500; etc. Here, "associated" means that the via is used, in one way or another, to electrically connect the corresponding contact to a conductive portion at the bottom side of the support.

Figure 4F is a bottom plan view of the module of FIG. 4E with the solar cells connected in parallel; this is achieved by interconnecting, on the one hand, all of the vias associated to the contacts of the first polarity type using a first conductive portion 108 on the bottom side of the support, and, on the other hand, all of the vias associated to the contacts of the second polarity type using a second conductive portion 107 on the bottom side of the support. Further, bypass diode 350 has been depicted in Figure 4F. Thus, it can easily be understood how by using vias as described and appropriately designing the conductive portions on the bottom side of the support, for example, by removing selected portions of an original conductive layer 103, the desired interconnection of the solar cells mounted on the front side of the support can be achieved, using the vias. In some embodiments, in addition to the interconnection of solar cells using the backplane (the conductive portions on the bottom side of the support), solar cells can also be interconnected, for example, in series, by using interconnects directly interconnecting solar cells on the front side of the support.

In some embodiments of the disclosure, the solar cells can be of the type described in U.S. Patent Application Serial No. 12/218,582 filed July 18, 2008.

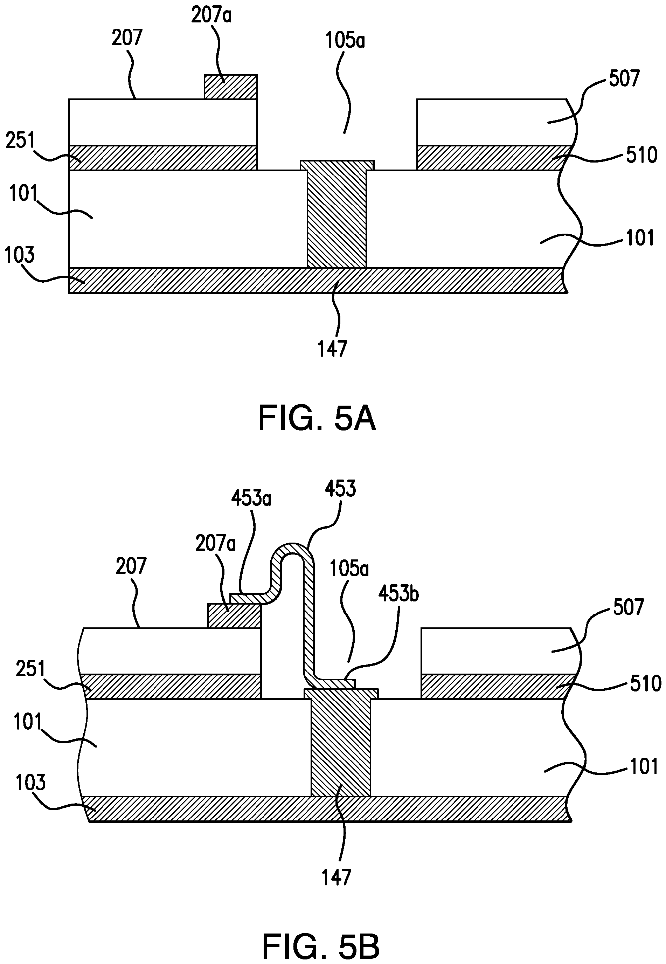

Figure 5A is a cross-sectional view of the support of FIG. 3A through the 5A-5A plane shown in FIG. 3A, and shows the corresponding part of the assembly prior to incorporation of the wire including the channel 105a and the via 147.

Figure 5B is a cross-sectional view of the support of FIG. 3A through the 5B-5B plane shown in FIG. 3A and illustrates the same part of the assembly after incorporation of the wire 453 in a first embodiment. Here, it can be seen how the wire 453 interconnects the contact pad 207a and the metal filling the via 147. A first end 453a of the wire is wire bonded to the contact pad 207a, and a second end 453b of the wire is wire bonded to the metal material filling the via 147, which in turn is connected to the bottom metal layer 103.

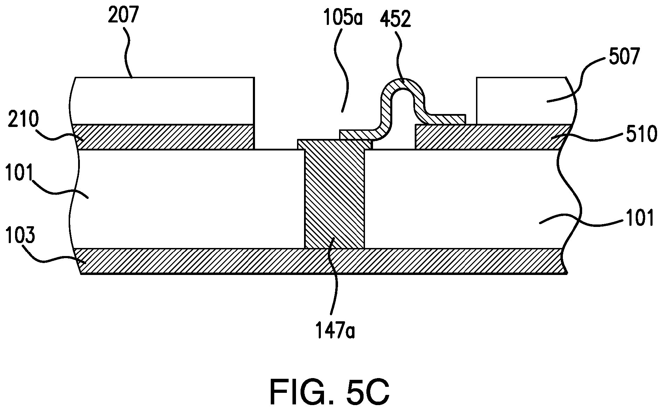

Figure 5C is a cross-sectional view of the support of FIG. 3A through the 5C-5C plane shown in FIG. 3A and illustrates the same part of the assembly after incorporation of the wire 452 in a first embodiment. Here, it can be seen how the wire 452 interconnects the bottom metal layer 510 of the solar cell 507 and the metal layer 103 on the bottom surface of the support 101, through the via 147a.

Although some specific embodiments of the present disclosure have been demonstrated in detail with examples, it should be understood by a person skilled in the art that the above examples are only intended to be illustrative but not to limit the scope of the present disclosure.

## Claims

1. A solar cell assembly comprising:
a support (100) comprising a first side and an opposing second side;
a first conductive layer (103) comprising first (108) and second (107) spaced-apart conductive portions disposed on the second side of the support (100);
a plurality of solar cells (200-207, 500-507, 810-817)) mounted on the first side of the support, each solar cell of the plurality of solar cells comprising a top surface including a contact of a first polarity type (210, 207a), and a rear surface including a contact of a second polarity type (251, 207b, 507b);
a plurality of first vias (301, 303, 305, 307, 309, 311, 313, 315) in the support extending from the first side of the support to the second side of the support;
a plurality of second vias (302, 304, 306, 308, 310, 312, 314, 316) in the support extending from the first side of the support to the second side of the support;
a plurality of first conductive interconnects (147) extending from the first side of the support to the first conductive portion of the first conductive layer, each respective interconnect making electrical contact with the contact of the first polarity type of a respective solar cell and extending through a respective one of the first vias to make electrical contact with the first conductive portion of the first conductive layer disposed on the second side of the support;
a plurality of second conductive interconnects (147a) extending from the first side of the support to the second conductive portion of the first conductive layer, each respective interconnect making electrical contact with the contact of the second polarity type of a respective solar cell and extending through a respective one of the second vias to make electrical contact with the second conductive portion of the first conductive layer disposed on the second side of the support; and
a first terminal (191) of the solar cell assembly of a first polarity type disposed on the second side of the support and connected to the first conductive portion (108) of the first conductive layer;
a second terminal (190) of the solar cell assembly of a second polarity type disposed on the second side of the support and connected to the second conductive portion (107) of the first conductive layer,
**characterized in that**
the solar cells have a size of less than 5 cm²,
and **in that**
the support is flexible.

2. A solar cell assembly as defined in claim 1, wherein the solar cells have a size of less than 1 cm².

3. A solar cell assembly as defined in any one of claims 1 and 2, wherein the support is a polyimide film.

4. A solar cell assembly as defined in any one of claims 1 and 2, wherein the support is composed of a poly (4,4'-oxydiphenylene-pyromellitimide) material.

5. A solar cell assembly as defined in claim 4, wherein the support has thickness of between 25 and 100 microns.

6. A solar cell assembly as defined in any one of the preceding claims, wherein the first conductive portion (108) of the first conductive layer comprises a plurality of parallel strips of equal width, and the second conductive portion (107) comprises a plurality of parallel strips of equal width, with the parallel strips of the first and second portions being interdigitated.

7. A solar cell assembly as defined in any one of the preceding claims, wherein the first and second conductive interconnect comprises an electroplated metal conductor extending from the surface of the first side of the support to the respective first and second conductive portions of the first conductive layer, or wherein each of the conductive interconnects comprises a single conductive element extending from the contact on the solar cell to the first or second conductive portions on the second side of the support through the via.

8. A solar cell assembly as defined in any one of the preceding claims, wherein each of the solar cells have a dimension in the range of 5 to 10 mm on a side, the support is a polyimide film having a thickness of between 25 and 100 microns, and is composed of a poly (4,4'-oxydiphenylene-pyromellitimide) material.

9. A solar cell assembly as defined in any one of the preceding claims, wherein the first terminal (191) of the assembly is disposed on a first peripheral edge of the assembly and connected to the first conductive portion (108) of the first conductive layer.

10. A solar cell assembly as defined in claim 9, wherein the second terminal (190) of the assembly is disposed on a second peripheral edge of the assembly extending parallel to the first peripheral edge of the assembly, and connected to the second conductive portion (107) of the first conductive layer.

11. A solar cell assembly as defined in any one of the preceding claims, further comprising a bypass diode (350) mounted in parallel with the solar cells and functioning as a bypass diode of the entire solar cell assembly, and has a top terminal of a first conductivity type and a bottom terminal of a second conductivity type, and the bottom terminal is mounted on and electrically connected to the first conductive layer.

12. A solar cell assembly as defined in claim 6, wherein the vias are arranged between the adjacent strips of the first and second conductive portions.

13. A solar cell assembly as defined in any one of the preceding claims, wherein the solar cells are discrete multijunction III/V compound semiconductor solar cells, and the solar cells are arranged in an array comprising not less than 9 and not more than 36 solar cells.

## Patentansprüche

1. Eine Solarzellenanordnung, umfassend:
einen Träger (100), der eine erste Seite und eine gegenüberliegende zweite Seite umfasst;
eine erste leitende Schicht (103), umfassend erste (108) und zweite (107) voneinander beabstandete leitende Abschnitte, die auf der zweiten Seite des Trägers (100) angeordnet sind;
mehrere Solarzellen (200-207, 500-507, 810-817), die auf der ersten Seite des Trägers angebracht sind, wobei jede Solarzelle der mehreren Solarzellen eine Oberseite mit einem Kontakt eines ersten Polaritätstyps (210, 207a) und eine Unterseite mit einem Kontakt eines zweiten Polaritätstyps (251, 207b, 507b) umfasst;
mehrere erste Durchkontaktierungen (301, 303, 305, 307, 309, 311, 313, 315) in dem Träger, die sich von der ersten Seite des Trägers zu der zweiten Seite des Trägers erstrecken;
mehrere zweite Durchkontaktierungen (302, 304, 306, 308, 310, 312, 314, 316) in dem Träger, die sich von der ersten Seite des Trägers zu der zweiten Seite des Trägers erstrecken;
mehrere erste leitende Verbindungen (147), die sich von der ersten Seite des Trägers bis zum ersten leitenden Abschnitt der ersten leitenden Schicht erstrecken, wobei diese Verbindungen jeweils einen elektrischen Kontakt mit dem Kontakt des ersten Polaritätstyps der entsprechenden Solarzelle herstellen und sich durch eine der ersten Durchkontaktierungen hindurch erstrecken, um einen elektrischen Kontakt mit dem ersten leitenden Abschnitt der ersten leitenden Schicht herzustellen, der auf der zweiten Seite des Trägers angeordnet ist;
mehrere zweite leitende Verbindungen (147a), die sich von der ersten Seite des Trägers bis zum zweiten leitenden Abschnitt der ersten leitenden Schicht erstrecken, wobei diese Verbindungen jeweils einen elektrischen Kontakt mit dem Kontakt des zweiten Polaritätstyps der entsprechenden Solarzelle herstellen und sich durch eine der zweiten Durchkontaktierungen hindurch erstrecken, um einen elektrischen Kontakt mit dem zweiten leitenden Abschnitt der ersten leitenden Schicht herzustellen, der auf der zweiten Seite des Trägers angeordnet ist; und
einen ersten Anschluss (191) der Solarzellenanordnung eines ersten Polaritätstyps, der auf der zweiten Seite des Trägers angeordnet und mit dem ersten leitenden Abschnitt (108) der ersten leitenden Schicht verbunden ist;
einen zweiten Anschluss (190) der Solarzellenanordnung eines zweiten Polaritätstyps, der auf der zweiten Seite des Trägers angeordnet und mit dem zweiten leitenden Abschnitt (107) der ersten leitenden Schicht verbunden ist,
**dadurch gekennzeichnet, dass**
die Solarzellen eine Größe von weniger als 5 cm² haben und dass
der Träger flexibel ist.

2. Solarzellenanordnung nach Anspruch 1, wobei die Solarzellen eine Größe von weniger als 1 cm² haben.

3. Solarzellenanordnung nach einem der Ansprüche 1 und 2, wobei der Träger eine Polyimidfolie ist.

4. Solarzellenanordnung nach einem der Ansprüche 1 und 2, wobei der Träger aus einem Poly (4,4'-Oxydiphenylen-Pyromellitimid)-Material besteht.

5. Solarzellenanordnung nach Anspruch 4, wobei der Träger eine Dicke zwischen 25 und 100 Mikrometer aufweist.

6. Solarzellenanordnung nach einem der vorhergehenden Ansprüche, wobei der erste leitende Abschnitt (108) der ersten leitenden Schicht mehrere parallele Streifen gleicher Breite umfasst und der zweite leitende Abschnitt (107) mehrere parallele Streifen gleicher Breite umfasst, wobei die parallelen Streifen des ersten und zweiten Abschnitts ineinandergreifen.

7. Solarzellenanordnung nach einem der vorhergehenden Ansprüche, wobei die erste und die zweite leitende Verbindung einen galvanisierten Metallleiter umfassen, der sich von der Oberfläche der ersten Seite des Trägers zu den entsprechenden ersten und zweiten leitenden Abschnitten der ersten leitenden Schicht erstreckt, oder wobei jede der leitenden Verbindungen ein einzelnes leitendes Element umfasst, das sich von dem Kontakt auf der Solarzelle zu dem ersten oder zweiten leitenden Abschnitt auf der zweiten Seite des Trägers durch die Durchkontaktierung erstreckt.

8. Solarzellenanordnung nach einem der vorhergehenden Ansprüche, wobei jede der Solarzellen auf einer Seite eine Größe im Bereich von 5 bis 10 mm aufweist, der Träger eine Polyimidfolie mit einer Dicke zwischen 25 und 100 Mikrometer ist und aus einem Poly (4,4'-Oxydiphenylen-Pyromellitimid)-Material besteht.

9. Solarzellenanordnung nach einem der vorhergehenden Ansprüche, wobei der erste Anschluss (191) der Anordnung an einer ersten Umfangskante der Anordnung angeordnet und mit dem ersten leitenden Abschnitt (108) der ersten leitenden Schicht verbunden ist.

10. Solarzellenanordnung nach Anspruch 9, wobei der zweite Anschluss (190) der Anordnung an einer zweiten Umfangskante der Anordnung angeordnet ist, die sich parallel zu der ersten Umfangskante der Anordnung erstreckt und mit dem zweiten leitenden Abschnitt (107) der ersten leitenden Schicht verbunden ist.

11. Solarzellenanordnung nach einem der vorhergehenden Ansprüche, ferner umfassend eine Überbrückungsdiode (350), die parallel zu den Solarzellen angebracht ist und als Überbrückungsdiode der gesamten Solarzellenanordnung dient und einen oberen Anschluss eines ersten Leitfähigkeitstyps und einen unteren Anschluss eines zweiten Leitfähigkeitstyps aufweist, wobei der untere Anschluss an der ersten leitenden Schicht angebracht und elektrisch mit dieser verbunden ist.

12. Solarzellenanordnung nach Anspruch 6, wobei die Durchkontaktierungen zwischen den benachbarten Streifen des ersten und des zweiten leitenden Abschnitts angeordnet sind.

13. Solarzellenanordnung nach einem der vorhergehenden Ansprüche, wobei die Solarzellen Mehrfach-Solarzellen aus diskreten III/V-Verbindungshalbleitern sind und die Solarzellen in einer Anordnung angeordnet sind, die nicht weniger als 9 und nicht mehr als 36 Solarzellen umfasst.

## Revendications

1. Ensemble de cellules solaires comprenant :
un support (100) comprenant un premier côté et un deuxième côté opposé ;
une première couche conductrice (103) comprenant des première (108) et deuxième (107) parties conductrices espacées disposées sur le deuxième côté du support (100) ;
une pluralité de cellules solaires (200 à 207, 500 à 507, 810 à 817) montées sur le premier côté du support, chaque cellule solaire de la pluralité de cellules solaires comprenant une surface supérieure comportant un contact d'un premier type de polarité (210, 207a), et une surface arrière comportant un contact d'un deuxième type de polarité (251, 207b, 507b) ;
une pluralité de premiers trous d'interconnexion (301, 303, 305, 307, 309, 311, 313, 315) dans le support s'étendant du premier côté du support au deuxième côté du support ;
une pluralité de deuxièmes trous d'interconnexion (302, 304, 306, 308, 310, 312, 314, 316) dans le support s'étendant du premier côté du support au deuxième côté du support ;
une pluralité de premières interconnexions conductrices (147) s'étendant du premier côté du support à la première partie conductrice de la première couche conductrice, chaque interconnexion respective établissant un contact électrique avec le contact du premier type de polarité d'une cellule solaire respective et s'étendant à travers un trou d'interconnexion respectif parmi les premiers trous d'interconnexion pour établir un contact électrique avec la première partie conductrice de la première couche conductrice disposée sur le deuxième côté du support ;
une pluralité de deuxièmes interconnexions conductrices (147a) s'étendant du premier côté du support à la deuxième partie conductrice de la première couche conductrice, chaque interconnexion respective établissant un contact électrique avec le contact du deuxième type de polarité d'une cellule solaire respective et s'étendant à travers un trou d'interconnexion respectif parmi les deuxièmes trous d'interconnexion pour établir un contact électrique avec la deuxième partie conductrice de la première couche conductrice disposée sur le deuxième côté du support ; et
une première borne (191) de l'ensemble de cellules solaires d'un premier type de polarité disposée sur le deuxième côté du support et connectée à la première partie conductrice (108) de la première couche conductrice ;
une deuxième borne (190) de l'ensemble de cellules solaires d'un deuxième type de polarité disposée sur le deuxième côté du support et connectée à la deuxième partie conductrice (107) de la première couche conductrice,
**caractérisé en ce que**
les cellules solaires possèdent une taille de moins de 5 cm²,
et **en ce que**
le support est souple.

2. Ensemble de cellules solaires selon la revendication 1, dans lequel les cellules solaires possèdent une taille de moins de 1 cm².

3. Ensemble de cellules solaires selon l'une quelconque des revendications 1 et 2, dans lequel le support est un film de polyimide.

4. Ensemble de cellules solaires selon l'une quelconque des revendications 1 et 2, dans lequel le support est composé d'un matériau de poly(4,4'-oxydiphénylène-pyromellitimide).

5. Ensemble de cellules solaires selon la revendication 4, dans lequel le support possède une épaisseur d'entre 25 et 100 microns.

6. Ensemble de cellules solaires selon l'une quelconque des revendications précédentes, dans lequel la première partie conductrice (108) de la première couche conductrice comprend une pluralité de bandes parallèles de largeur égale, et la deuxième partie conductrice (107) comprend une pluralité de bandes parallèles de largeur égale, les bandes parallèles des première et deuxième parties étant interdigitées.

7. Ensemble de cellules solaires selon l'une quelconque des revendications précédentes, dans lequel la première et la deuxième interconnexion conductrice comprend un conducteur métallique électrolytique s'étendant de la surface du premier côté du support aux première et deuxième parties conductrices respectives de la première couche conductrice, ou dans lequel chacune des interconnexions conductrices comprend un unique élément conducteur s'étendant du contact sur la cellule solaire aux première ou deuxième parties conductrices sur le deuxième côté du support à travers le trou d'interconnexion.

8. Ensemble de cellules solaires selon l'une quelconque des revendications précédentes, dans lequel chacune des cellules solaires possède une dimension dans la plage de 5 à 10 mm sur un côté, le support est un film de polyimide ayant une épaisseur d'entre 25 et 100 microns, et est composé d'un matériau de poly(4,4'-oxydiphénylène-pyromellitimide).

9. Ensemble de cellules solaires selon l'une quelconque des revendications précédentes, dans lequel la première borne (191) de l'ensemble est disposée sur un premier bord périphérique de l'ensemble et connectée à la première partie conductrice (108) de la première couche conductrice.

10. Ensemble de cellules solaires selon la revendication 9, dans lequel la deuxième borne (190) de l'ensemble est disposée sur un deuxième bord périphérique de l'ensemble s'étendant parallèlement au premier bord périphérique de l'ensemble, et connectée à la deuxième partie conductrice (107) de la première couche conductrice.

11. Ensemble de cellules solaires selon l'une quelconque des revendications précédentes, comprenant en outre une diode de dérivation (350) montée en parallèle avec les cellules solaires et fonctionnant comme une diode de dérivation de la totalité de l'ensemble de cellules solaires, et qui possède une borne supérieure d'un premier type de conductivité et une borne inférieure d'un deuxième type de conductivité, et la borne inférieure est montée sur et électriquement connectée à la première couche conductrice.

12. Ensemble de cellules solaires selon la revendication 6, dans lequel les trous d'interconnexion sont agencés entre les bandes adjacentes des première et deuxième parties conductrices.

13. Ensemble de cellules solaires selon l'une quelconque des revendications précédentes, dans lequel les cellules solaires sont des cellules solaires individuelles à semi-conducteur à composé du groupe III/V à jonctions multiples, et les cellules solaires sont agencées selon une matrice comprenant pas moins de 9 et pas plus de 36 cellules solaires.
